# EUROPEAN PATENT APPLICATION

(11) **EP 3 734 241 A1**
(43) Date of publication of application: **04.11.2020**
(21) Application number: 18893823.7
(22) Date of filing: 25.12.2018
(51) Int. Cl.: G01J 1/02

(54) **PHOTODETECTOR**

(30) Priority: 28.12.2017 JP 2017254336
(71) Applicant: Murata Manufacturing Co., Ltd., Nagaokakyo-shi, Kyoto 617-8555 (JP)
(72) Inventor: MATSUI, Masatsugu, Nagaokakyo-shi, Kyoto 617-8555 (JP); ICHIMARU, Masayuki, Nagaokakyo-shi, Kyoto 617-8555 (JP); EIYAMA, Daichi, Nagaokakyo-shi, Kyoto 617-8555 (JP)
(74) Representative: Reeve, Nicholas Edward
(86) International application number: PCT/JP2018/047591
(87) International publication number: WO 2019/131642

(57) **Abstract**

A photodetector (10) includes a stem (40) having electrical conductivity, a pyroelectric element (20), a conductor pin (511), and a conductor pin (512). The pyroelectric element (20) is arranged on the front surface side of the stem (40) and has a structure including a first light receiving portion (201) and a second light receiving portion (202) that are connected in series and that generate voltages of opposite polarities upon receiving light. Each of the conductor pin (511) and the conductor pin (512) has a shape projecting from a front surface of the stem (40) and has thermal conductivity. A shortest distance for heat conduction between the conductor pin (511) and the first light receiving portion (201) and a shortest distance for heat conduction between the conductor pin (512) and the second light receiving portion (202) are the same.

## Description

### Technical Field

The present invention relates to a pyroelectric photodetector in which a light receiving electrode is formed on a pyroelectric body.

### Background Art

Patent Document 1 discloses, as one type of photodetector, an infrared sensor using a pyroelectric element. The related-art infrared sensor disclosed in Patent Document 1 includes a stem, a pyroelectric element, and a conversion circuit. Various circuit elements and conductor patterns, which constitute the conversion circuit, are formed on a front surface of the stem. The pyroelectric element is arranged on the front surface side of the stem at a position away from the front surface of the stem.

In the above related-art infrared sensor, one end of the pyroelectric element is connected to a ground potential, and the other end is connected to the conversion circuit. The stem is provided with three lead-out terminals penetrating through the stem. The three lead-out terminals are disposed as a terminal connecting the one end of the pyroelectric element to the ground potential, a terminal through which a drive voltage for the conversion circuit is applied, and a terminal through which an output voltage of the conversion circuit is output to the outside. The three lead-out terminals are arranged around the pyroelectric element when viewed in plan.

In the related-art infrared sensor, the pyroelectric element has a pair of light receiving electrodes in order to prevent malfunction caused by variations in background temperature (ambient atmosphere).

### Citation List

### Patent Document

Patent Document 1: Japanese Unexamined Patent Application Publication No. 11-337406

### Summary of Invention

### Technical Problem

However, the structure of the related-art infrared sensor has the following problem. When the stem is made of a material having high electrical conductivity, such as a metal, electrical characteristics are improved, but the infrared sensor may malfunction due to the so-called WLI (White Light Immunity) under condition that the infrared sensor receives strong light from the outside.

Accordingly, an object of the present invention is to provide a photodetector that has electrical characteristics improved in comparison with those obtained with the related-art structure, and that can suppress the occurrence of malfunction.

### Solution to Problem

The present invention provides a photodetector including a stem having electrical conductivity, a pyroelectric element, a first projecting portion, and a second projecting portion. The pyroelectric element is arranged on the front surface side of the stem and has a structure including a first light receiving portion and a second light receiving portion that are connected in series and that generate voltages of opposite polarities upon receiving light. Each of the first projecting portion and the second projecting portion has a shape projecting from a front surface of the stem and has thermal conductivity. A shortest distance for heat conduction between the first projecting portion and the first light receiving portion and a shortest distance for heat conduction between the second projecting portion and the second light receiving portion are the same.

With the above-described feature, when the stem is illuminated with strong light from the outside and heat is generated in the stem, an amount of the heat transferred to the first light receiving portion through the first projecting portion and an amount of the heat transferred to the second light receiving portion through the second projecting portion are the same. As a result, a voltage generated in the first light receiving portion and a voltage generated in the second light receiving portion due to the heat from the outside are the same and cancelled each other.

The present invention further provides a photodetector including a stem having electrical conductivity, a pyroelectric element, a first projecting portion, and a second projecting portion. The pyroelectric element is arranged on the front surface side of the stem and has a structure including a first light receiving portion and a second light receiving portion that are connected in series and that generate voltages of opposite polarities upon receiving light. Each of the first projecting portion and the second projecting portion has a shape projecting from a front surface of the stem and has thermal conductivity. When viewing the front surface of the stem from above, a physical shortest distance between the first projecting portion and the first light receiving portion and a physical shortest distance between the second projecting portion and the second light receiving portion are the same.

With the above-described feature, when the stem is illuminated with strong light from the outside and heat is generated in the stem, a difference between an amount of the heat transferred to the first light receiving portion through the first projecting portion and an amount of the heat transferred to the second light receiving portion through the second projecting portion is reduced. As a result, the voltage generated in the first light receiving portion and the voltage generated in the second light receiving portion due to the heat from the outside are the same and cancelled each other.

In the photodetector according to the present invention, preferably, when viewing the pyroelectric element in plan, a pair of the first projecting portion and the second light receiving portion and a pair of the first light receiving portion and the second light receiving portion are symmetrically arranged for each pair about a center or a center line of the pyroelectric element.

With the above-described feature, the balance between the voltage generated in the first light receiving portion and the voltage generated in the second light receiving portion are improved, and the effect of offsetting the influence of variations in background temperature (ambient atmosphere) is more reliable.

The photodetector according to the present invention is preferably constituted as follows. The photodetector further includes a circuit board in the form of a flat plate, the circuit board including a circuit electrically connected to the pyroelectric element. The pyroelectric element is mounted to a surface of the circuit board. The first projecting portion and the second projecting portion are physically and electrically connected to the circuit board.

With the above-described feature, a transfer path of the heat caused by the strong light from the outside is mainly constituted by the circuit board. Furthermore, since the pyroelectric element, the first projecting portion, and the second projecting portion are fixed to the circuit board, the above-mentioned shortest distance for heat conduction between the first projecting portion and the first light receiving portion and the above-mentioned shortest distance for heat conduction between the second projecting portion and the second light receiving portion are accurately and stably realized.

The photodetector according to the present invention is preferably constituted as follows. The circuit board includes a first conductor pattern electrically connected to the first light receiving portion of the pyroelectric element, and a second conductor pattern electrically connected to the second light receiving portion of the pyroelectric element. The first conductor pattern and the second conductor pattern have zones that are arranged parallel and apart from each other when viewing the circuit board in plan.

With the above-described feature, heat exchange between the heat transferred through the first conductor pattern and the heat transferred through the second conductor pattern is promoted in the above-mentioned parallel zones. As a result, the heat transferred to the first light receiving portion through the first conductor pattern and the heat transferred to the second light receiving portion through the second conductor pattern become more even.

The photodetector according to the present invention is preferably constituted as follows. The first light receiving portion of the pyroelectric element is electrically connected to the first conductor pattern through a first connection member. The second light receiving portion of the pyroelectric element is electrically connected to the second conductor pattern through a second connection member. When viewing the circuit board in plan, the first conductor pattern and the second conductor pattern have zones in which the first conductor pattern and the second conductor pattern are arranged parallel to be kept apart from each other at a middle point between the first connection member and the second connection member.

With the above-described feature, a distance for heat conduction from the zones in which both the conductor patterns are arranged parallel to the first connection member and a distance for heat conduction from the zones in which both the conductor patterns are arranged parallel to the second connection member are substantially the same. As a result, the heat conduction to the first light receiving portion and the heat conduction to the second light receiving portion become more even.

In the photodetector according to the present invention, preferably, the first conductor pattern and the second conductor pattern have narrower widths in other zones than the zones in which the first conductor pattern and the second conductor pattern are arranged parallel.

With the above-described feature, the efficiency of the heat exchange in the zones in which the first conductor pattern and the second conductor pattern are arranged parallel is improved. In addition, heat transfer through the other zones than the zones in which the first conductor pattern and the second conductor pattern are arranged parallel (namely through the zones in which both the conductor patterns have the narrower widths) is suppressed.

In the photodetector according to the present invention, preferably, the other narrower zones than the zones in which the first conductor pattern and the second conductor pattern are arranged parallel are formed on both the sides of the parallel zone in each of the first conductor pattern and the second conductor pattern.

With the above-described feature, heat tends to concentrate in the zones in which the first conductor pattern and the second conductor pattern are arranged parallel. As a result, the efficiency of the heat exchange is increased.

In the photodetector according to the present invention, preferably, at least one of the first projecting portion and the second projecting portion is a grounding lead-out terminal that grounds a circuit electrically connected to the pyroelectric element.

With the above-described feature, the above-mentioned cancellation of the voltages generated by the heat in the first light receiving portion and the second light receiving portion is realized with the aid of the lead-out terminal having the electrical function. As a result, the structure of the photodetector capable of cancelling the voltages generated by the heat in the first light receiving portion and the second light receiving portion can be simplified. Advantageous Effects of Invention

According to the present invention, the photodetector can be realized which has good electrical characteristics and which can suppress the occurrence of malfunction. Brief Description of Drawings
[Fig. 1] Fig. 1 is a plan view illustrating a main structure of a photodetector 10 according to a first embodiment of the present invention.
[Fig. 2] Fig. 2 is a perspective view of the photodetector 10 according to the first embodiment of the present invention.
[Fig. 3] Fig. 3 is an exploded perspective view of the photodetector 10 according to the first embodiment of the present invention.
[Fig. 4] Fig. 4 is a side view illustrating part of the structure of the photodetector 10 according to the first embodiment of the present invention.
[Fig. 5] Fig. 5 is an equivalent circuit diagram of the photodetector 10 according to the first embodiment of the present invention.
[Fig. 6] Fig. 6(A) is a plan view of a pyroelectric element 20 according to the first embodiment of the present invention, Fig. 6(B) is a side sectional view of the pyroelectric element 20, and Fig. 6(C) is a bottom view of the pyroelectric element 20.
[Fig. 7] Fig. 7(A) is a plan view of a circuit board 30 according to the first embodiment of the present invention, and Fig. 7(B) is a rear view of the circuit board 30.
[Fig. 8] Fig. 8(A) illustrates a simulation result of heat conduction in the structure of the photodetector 10 according to the embodiment of the present invention, and Fig. 8(B) illustrates a simulation result of heat conduction in a comparative structure.
[Fig. 9] Fig. 9 is a plan view illustrating a main structure of a photodetector 10A according to a second embodiment of the present invention.
[Fig. 10] Fig. 10(A) is a plan view of a pyroelectric element 20A according to the second embodiment of the present invention, Fig. 10(B) is a side sectional view of the pyroelectric element 20A, and Fig. 10(C) is a bottom view of the pyroelectric element 20A.
[Fig. 11] Fig. 11 is a plan view illustrating a main structure of a photodetector 10B according to a third embodiment of the present invention.
[Fig. 12] Fig. 12 is an exploded perspective view of a photodetector 10C according to a fourth embodiment of the present invention.

### Description of Embodiments

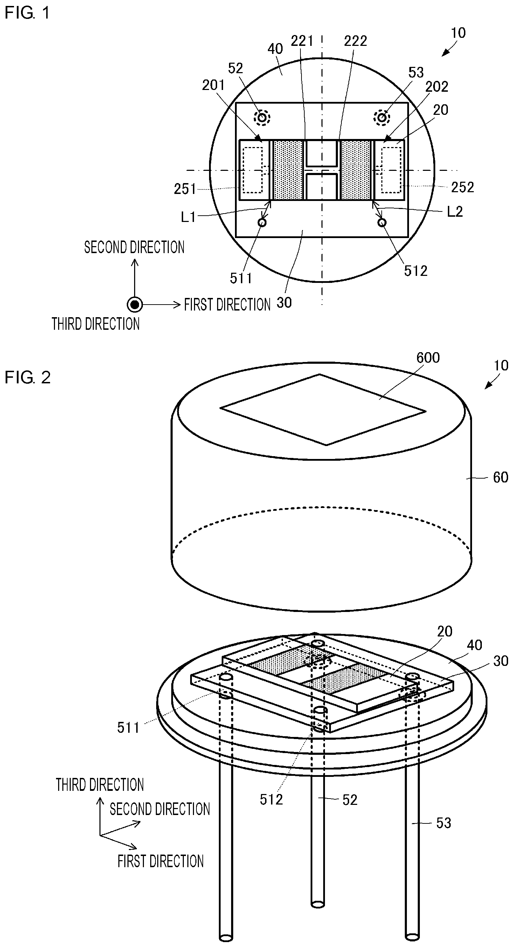

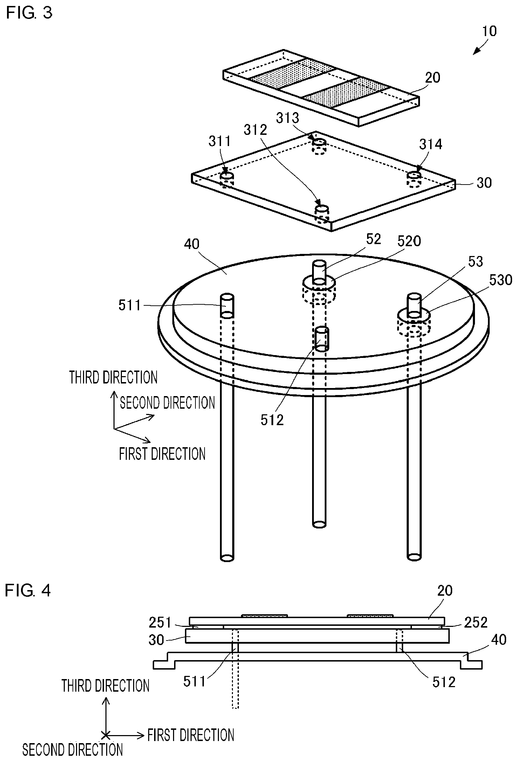

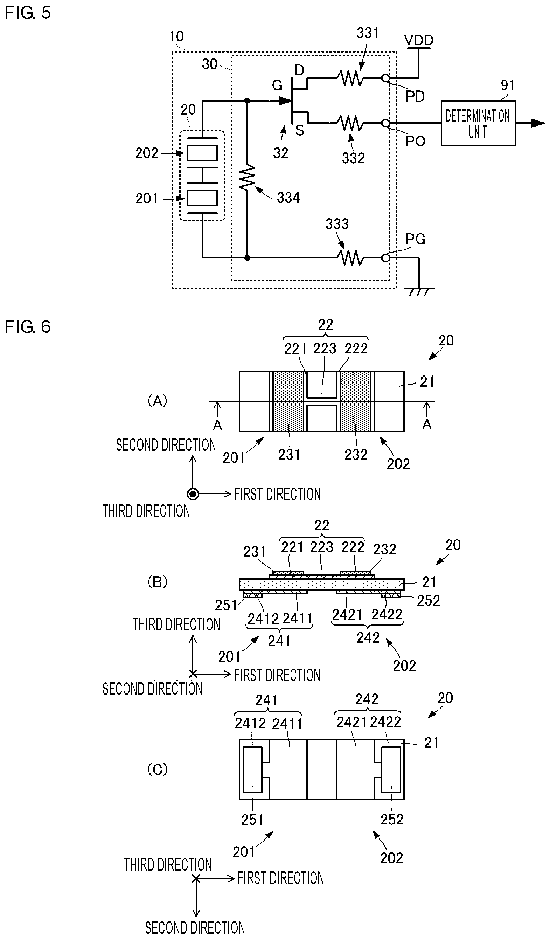

A photodetector according to a first embodiment of the present invention will be described with reference to the drawings. Fig. 1 is a plan view illustrating a main structure of a photodetector 10 according to the first embodiment of the present invention. Fig. 2 is a perspective view of the photodetector 10 according to the first embodiment of the present invention. Fig. 3 is an exploded perspective view of the photodetector 10 according to the first embodiment of the present invention. In Fig. 3, a cover is omitted. Fig. 4 is a side view illustrating part of the structure of the photodetector 10 according to the first embodiment of the present invention. Fig. 5 is an equivalent circuit diagram of an optical detection device including the photodetector 10 according to the first embodiment of the present invention.

First, a circuit configuration of the photodetector 10 is described with reference to Fig. 5. The photodetector 10 includes a pyroelectric element 20 and a circuit board 30 for use in realizing a conversion circuit.

The pyroelectric element 20 includes a first light receiving portion 201 and a second light receiving portion 202 that are connected in series. Upon receiving light applied from the outside in common to both the first light receiving portion 201 and the second light receiving portion 202 from the outside, the first light receiving portion 201 and the second light receiving portion 202 generate potential differences (voltages) of opposite polarities.

The circuit board 30 includes an FET 32 for amplification, a resistance element 331, a resistance element 332, a resistance element 333, and a resistance element 334.

The first light receiving portion 201 of the pyroelectric element 20 is connected to a terminal PG through the resistance element 333. The terminal PG is a terminal for grounding. The resistance element 334 is connected in parallel to the pyroelectric element 20.

The second light receiving portion 202 of the pyroelectric element 20 is connected to a gate of the FET 32. A drain of the FET 32 is connected to a terminal PD through the resistance element 331. The terminal PD is a terminal to which a drive voltage VDD is applied. A source of the FET 32 is connected to a terminal PO through the resistance element 332. The terminal PO is connected to a determination unit 91.

In the above-described configuration, the pyroelectric element 20 generates a detection voltage due to heat applied from a target to be detected. The FET 32 amplifies the detection voltage. The determination unit 91 is constituted by an IC and so on, and determines, for example, the presence or the absence of the target to be detected in accordance with the voltage at the terminal PO of the photodetector 10 by using a known method.

Here, when an amount of heat attributable to unwanted light from the outside is small, the voltage generated in the first light receiving portion 201 and the voltage generated in the second light receiving portion 202 are cancelled each other. Accordingly, the occurrence of false detection is suppressed. Moreover, even when the amount of the heat attributable to the unwanted light from the outside is large, the occurrence of malfunction caused by the unwanted light from the outside is also suppressed by adopting features described below.

Looking from the structural point of view, as illustrated in Figs. 1, 2, 3 and 4, the photodetector 10 includes the pyroelectric element 20, the circuit board 30, a stem 40, a conductor pin 511, a conductor pin 512, a conductor pin 52, a conductor pin 53, and a cover 60.

The stem 40 is substantially in the form of a flat plate when viewed in plan (namely, when viewed in a third direction denoted in Figs. 2 and 3). The stem 40 is made of a material having electrical conductivity and thermal conductivity, such as a metal. The stem 40 has a diameter of about 9 mm, for example. The stem size is not limited to such an example.

The conductor pin 511, the conductor pin 512, the conductor pin 52, and the conductor pin 53 are each in the form of a rod and are made of a material having high electrical conductivity, such as a metal. The conductor pin 511, the conductor pin 52, and the conductor pin 53 penetrate through the stem 40 in a thickness direction (third direction denoted in Fig. 3), and they project to both the front surface side and the rear surface side of the stem 40. Here, in each of the conductor pin 511, the conductor pin 52, and the conductor pin 53, a projection length on the front surface side is smaller than that on the rear surface side. The conductor pin 512 projects to the front surface side of the stem 40. A portion of the conductor pin 511 projecting to the front surface side of the stem 40 corresponds to a "first projecting portion" in the present invention. The conductor pin 512 corresponds to a "second projecting portion" in the present invention. The heights and the diameters of the first projecting portion and the second projecting portion are preferably the same between both the projecting portions.

The conductor pin 511 and the conductor pin 512 are electrically and physically connected to the stem 40. The conductor pin 52 is physically connected to the stem 40 with an insulator 520 interposed therebetween. The conductor pin 53 is physically connected to the stem 40 with an insulator 530 interposed therebetween. In other words, the conductor pin 52 and the conductor pin 53 are physically connected to the stem 40 in an electrically insulated state.

In the above-described structure, the conductor pin 511 and the conductor pin 512 correspond to the terminal PG for grounding. The conductor pin 52 corresponds to the terminal PO through which the detection voltage is output. The conductor pin 53 corresponds to the terminal PD through which the drive voltage VDD is applied. Thus, the photodetector 10 having high electrical conductivity can be realized by using the conductor pin 511, the conductor pin 512, the conductor pin 52, and the conductor pin 53 as the terminals for connection to the outside. Furthermore, a ground potential is stabilized by using the conductor pin 511 and the conductor pin 512 as the terminal PG for grounding and by utilizing the stem 40 for grounding. As a result, the grounding of the photodetector 10 is stabilized and the performance in detection of the target to be detected is improved.

The cover 60 has a tubular shape and covers the front surface side of the stem 40 while defining an inner space in which the pyroelectric element 20 and the circuit board 30 are disposed. A condenser lens 600 is arranged at a top surface of the cover 60. The condenser lens 600 condenses the light from the outside to the pyroelectric element 20.

The circuit board 30 is in the form of a flat plate mainly made of a resin material and having a rectangular shape when viewed in plan. The circuit board 30 is mounted to the front surface side of the stem 40. The size of the circuit board 30 is about 5 mm × about 6 mm, for example, but the board size is not limited to such an example. Although a detailed structure of the circuit board 30 will be described later, a through-hole 311, a through-hole 312, a through-hole 313, and a through-hole 314 are formed in the circuit board 30 to penetrate through the same from the front surface side to the rear surface side. The conductor pin 511 is fitted into the through-hole 311, and the conductor pin 512 is fitted into the through-hole 312. The conductor pin 52 is fitted into the through-hole 313, and the conductor pin 53 is fitted into the through-hole 314. With the above-described structure, the circuit board 30 is fixed in a state apart from a front surface of the stem 40 with a certain distance kept therebetween.

The pyroelectric element 20 is in the form of a flat plate having a rectangular shape when viewed in plan. The pyroelectric element 20 is mounted to a front surface of the circuit board 30. Here, a rear surface of the pyroelectric element 20 and the front surface of the circuit board 30 are substantially parallel to each other. Moreover, the rear surface of the pyroelectric element 20 and the front surface of the circuit board 30 are kept apart from each other. In addition, the pyroelectric element 20 is arranged at a center of the circuit board 30 when viewed in plan. The conductor pin 511 and the conductor pin 512 are arranged on the same side as one end of the pyroelectric element 20 in a second direction, while the conductor pin 52 and the conductor pin 53 arranged on the same side as the other end of the pyroelectric element 20 in the second direction.

Fig. 6(A) is a plan view of the pyroelectric element 20 according to the first embodiment of the present invention, Fig. 6(B) is a side sectional view of the pyroelectric element 20, and Fig. 6(C) is a bottom view of the pyroelectric element 20.

As illustrated in Figs. 6(A), 6(B) and 6(C), the pyroelectric element 20 includes a pyroelectric body 21, a detection electrode 22, a blackened film 231, a blackened film 232, a connection electrode 241, a connection electrode 242, a connection member 251, and a connection member 252.

The pyroelectric body 21 is in the form of a rectangular flat plate with a length in a first direction being longer than that in the second direction. The detection electrode 22 is formed on a front surface of the pyroelectric body 21. The pyroelectric body 21 is polarized in the third direction, for example.

The detection electrode 22 includes a first electrode 221, a second electrode 222, and a connection electrode 223. The first electrode 221 and the second electrode 222 are rectangular and are arranged apart from each other in the first direction. Preferably, a length of each of the first electrode 221 and the second electrode 222 in the second direction is the same as that of the pyroelectric body 21 in the second direction. The connection electrode 223 is arranged between the first electrode 221 and the second electrode 222 to connect between the first electrode 221 and the second electrode 222.

The blackened film 231 is formed to cover substantially an entire surface of the first electrode 221. The blackened film 232 is formed to cover substantially an entire surface of the second electrode 222.

The connection electrode 241 is constituted by a rectangular portion 2411 that is opposed to the first electrode 221 with the pyroelectric body 21 interposed therebetween, a rectangular portion 2412 for connection to the outside, and a connection portion that connects between both the rectangular portions. The rectangular portion 2412 for connection to the outside is formed near one end of the pyroelectric body 21 in the first direction. The connection member 251 is arranged on an outer surface (rear surface) of the rectangular portion for connection to the outside.

The connection electrode 242 is constituted by a rectangular portion 2421 that is opposed to the second electrode 222 with the pyroelectric body 21 interposed therebetween, a rectangular portion 2422 for connection to the outside, and a connection portion that connects between both the rectangular portions. The rectangular portion 2422 for connection to the outside is formed near the other end of the pyroelectric body 21 in the first direction. The connection member 252 is arranged on an outer surface (rear surface) of the rectangular portion for connection to the outside.

According to the above-described structure, the first light receiving portion 201 of the pyroelectric element 20 is mainly formed by a region where the pyroelectric body 21 is sandwiched between the first electrode 221 and the rectangular portion 2411. The second light receiving portion 202 of the pyroelectric element 20 is mainly formed by a region where the pyroelectric body 21 is sandwiched between the second electrode 222 and the rectangular portion 2421.

In the above-described structure, when viewing the photodetector 10 in plan, a shortest distance (L1 in Fig. 1) between the first light receiving portion 201 of the pyroelectric element 20 and the conductor pin 511 and a shortest distance (L2 in Fig. 1) between the second light receiving portion 202 of the pyroelectric element 20 and the conductor pin 512 are the same. To express the definition in a different way, a shortest distance between a partial region of the pyroelectric element 20 where the pyroelectric body 21 is sandwiched between the first electrode 221 and the rectangular portion 2411 and the conductor pin 511 and a shortest distance between a partial region of the pyroelectric element 20 where the pyroelectric body 21 is sandwiched between the second electrode 222 and the rectangular portion 2421 and the conductor pin 512 are the same.

Here, a medium for heat conduction between the first light receiving portion 201 of the pyroelectric element 20 and the conductor pin 511 is mainly the circuit board 30, and a medium for heat conduction between the second light receiving portion 202 of the pyroelectric element 20 and the conductor pin 512 is also mainly the circuit board 30. In other words, the medium for heat conduction between the first light receiving portion 201 of the pyroelectric element 20 and the conductor pin 511 and the medium for heat conduction between the second light receiving portion 202 of the pyroelectric element 20 and the conductor pin 512 are the same. Thus, according to the above-described structure, a shortest distance for heat conduction between the first light receiving portion 201 of the pyroelectric element 20 and the conductor pin 511 and a shortest distance for heat conduction between the second light receiving portion 202 of the pyroelectric element 20 and the conductor pin 512 are the same. The word "same" used here and in the following description stands for not only the case in which two values are exactly the same, but also the case in which two values are the same with an allowable range of error between the two values.

When strong light hits the photodetector 10 from the outside and heat generates in the stem 40, the heat is transferred to the first light receiving portion 201 of the pyroelectric element 20 through the conductor pin 511 and to the second light receiving portion 202 of the pyroelectric element 20 through the conductor pin 512. Here, an amount of the heat transferred to the first light receiving portion 201 and an amount of the heat transferred to the second light receiving portion 202 become the same by setting the distance between the conductor pin 511 and the pyroelectric element 20 and the distance between the conductor pin 512 and the pyroelectric element 20 as per described above.

Accordingly, the voltage generated in the first light receiving portion 201 due to the heat caused by the strong light from the outside and the voltage generated in the second light receiving portion 202 due to the heat caused by the strong light from the outside are cancelled each other. As a result, false detection attributable to the heat generated in the stem 40 by the strong light from the outside can be suppressed.

As described above, with the structure according to this embodiment, it is possible to suppress the false detection attributable to the heat generated in the stem 40 by the strong light from the outside, and to realize the photodetector 10 having high performance in detection of the target to be detected.

Preferably, when viewing the pyroelectric element 20 in plan, a pair of the first light receiving portion 201 and the second light receiving portion 202, a pair of the first electrode 221 and the second electrode 222, a pair of the rectangular portion 2411 and the rectangular portion 2421, and a pair of the conductor pin 511 and the conductor pin 512 are symmetrically arranged for each pair about a center line that passes the center of the pyroelectric element 20 and that extends in the second direction. With such an arrangement, the balance between the voltage generated in the first light receiving portion 201 and the voltage generated in the second light receiving portion 202 are improved, and the effect of offsetting the influence by variations in background temperature (ambient atmosphere) is more reliable.

More preferably, the connection member 251 and the connection member 252 are also symmetrically arranged about the center line. With such an arrangement, the above-described effect of cancelling the voltages generated in the first light receiving portion 201 and the second light receiving portion 202 each other is even more reliable.

In addition, with the circuit board 30 having a structure described below, the photodetector 10 can more reliably suppress the false detection attributable to the heat generated in the stem 40 by the strong light from the outside.

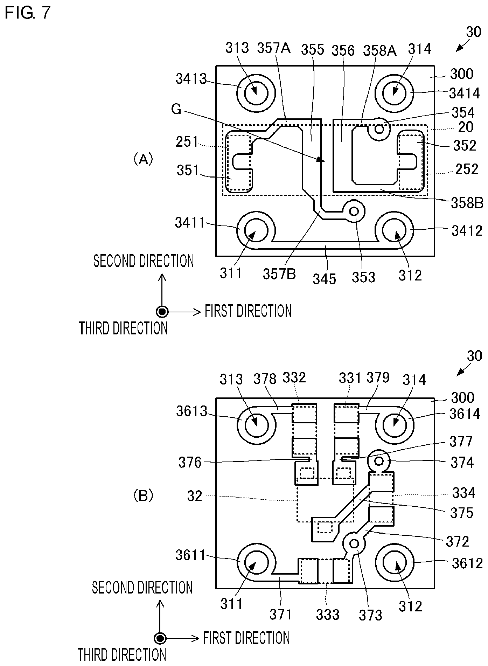

Fig. 7(A) is a plan view of the circuit board 30 according to the first embodiment of the present invention, and Fig. 7(B) is a rear view of the circuit board 30 (the view illustrating a rear surface of the circuit board when seeing through the circuit board in plan from the side facing the pyroelectric element).

As illustrated in Figs. 7(A) and 7(B), the circuit board 30 includes a resin substrate 300 and a plurality of electrode patterns. An electrode pattern 3411, an electrode pattern 3412, an electrode pattern 3413, an electrode pattern 3414, an electrode pattern 345, an electrode pattern 351, an electrode pattern 352, an electrode pattern 353, an electrode pattern 354, an electrode pattern 355, an electrode pattern 356, an electrode pattern 357A, an electrode pattern 357B, an electrode pattern 358A, and an electrode pattern 358B are formed on a front surface of the resin substrate 300.

The electrode pattern 3411, the electrode pattern 3412, the electrode pattern 3413, and the electrode pattern 3414 have shapes encompassing outer edges of the through-hole 311, the through-hole 312, the through-hole 313, and the through-hole 314, respectively. The electrode pattern 345 has a linear shape extending in the first direction and connects between the electrode pattern 3411 and the electrode pattern 3412.

The electrode pattern 351 and the electrode pattern 352 are substantially rectangular. The electrode pattern 351 and the electrode pattern 352 are arranged substantially at a center of the resin substrate 300 in the second direction. The electrode pattern 351 is arranged near one end of the resin substrate 300 in the first direction, and the electrode pattern 352 is arranged near the other end of the resin substrate 300 in the first direction. The connection member 251 of the pyroelectric element 20 is mounted to the electrode pattern 351, and the connection member 252 of the pyroelectric element 20 is mounted to the electrode pattern 352.

The electrode pattern 351 is connected to the electrode pattern 353 through the electrode pattern 357A, the electrode pattern 355, and the electrode pattern 357B. The electrode pattern 357A, the electrode pattern 355, and the electrode pattern 357B are all linear, and a width of the electrode pattern 355 is greater than that of each of the electrode pattern 357A and the electrode pattern 357B. Note that the term "width" stands for a length in a direction perpendicular to the flow direction of a current when viewing the circuit board in plan.

The electrode pattern 352 is connected to the electrode pattern 354 through the electrode pattern 358A, the electrode pattern 356, and the electrode pattern 358B. The electrode pattern 358A, the electrode pattern 356, and the electrode pattern 358B are all linear, and a width of the electrode pattern 356 is greater than that of each of the electrode pattern 358A and the electrode pattern 358B.

An electrode pattern 3611, an electrode pattern 3612, an electrode pattern 3613, an electrode pattern 3614, an electrode pattern 371, an electrode pattern 372, an electrode pattern 373, an electrode pattern 374, an electrode pattern 375, an electrode pattern 376, an electrode pattern 377, an electrode pattern 378, and an electrode pattern 379 are formed on a rear surface of the resin substrate 300.

The electrode pattern 3611, the electrode pattern 3612, the electrode pattern 3613, and the electrode pattern 3614 have shapes encompassing outer edges of the through-hole 311, the through-hole 312, the through-hole 313, and the through-hole 314, respectively. The electrode pattern 3611 is connected to the electrode pattern 3411 through an electrode pattern formed in the through-hole 311. The electrode pattern 3612 is connected to the electrode pattern 3412 through an electrode pattern formed in the through-hole 312. The electrode pattern 3613 is connected to the electrode pattern 3413 through an electrode pattern formed in the through-hole 313. The electrode pattern 3614 is connected to the electrode pattern 3414 through an electrode pattern formed in the through-hole 314.

The electrode pattern 371 is connected to the electrode pattern 3611, and one end of the resistance element 333 is mounted to the electrode pattern 371. The other end of the resistance element 333 is mounted to one end of the electrode pattern 372 in an extension direction thereof, and one end of the resistance element 334 is mounted to the other end of the electrode pattern 372 in the extension direction. The electrode pattern 373 is located at an intermediate position of the electrode pattern 372 in the extension direction, and is connected to the electrode pattern 353 by a conductor penetrating through the resin substrate 300.

The electrode pattern 374 is connected to the electrode pattern 354 by a conductor penetrating through the resin substrate 300.

The other end of the resistance element 334 is mounted to one end of the electrode pattern 375 in an extension direction thereof and is further connected to the electrode pattern 374. A gate terminal of the FET 32 is mounted to the other end of the electrode pattern 375 in the extension direction.

A source terminal of the FET 32 is mounted to the electrode pattern 376, and one end of the resistance element 332 is also mounted to the electrode pattern 376. A drain terminal of the FET 32 is mounted to the electrode pattern 377, and one end of the resistance element 331 is also mounted to the electrode pattern 377.

The electrode pattern 378 is connected to the electrode pattern 3613, and the other end of the resistance element 332 is mounted to the electrode pattern 378. The electrode pattern 379 is connected to the electrode pattern 3614, and the other end of the resistance element 331 is mounted to the electrode pattern 379.

In the above-described structure, as illustrated in Fig. 7(A), the electrode pattern 355 connected to the electrode pattern 351 and the electrode pattern 356 connected to the electrode pattern 352 are arranged parallel over a predetermined length along the second direction. Moreover, the electrode pattern 355 and the electrode pattern 356 are arranged apart from each other in the first direction. Stated in another way, the electrode pattern 355 and the electrode pattern 356 are arranged such that a gap G having a predetermined width in the first direction is interposed between both the electrode patterns. With that arrangement, heat exchange between the electrode pattern 355 and the electrode pattern 356 is promoted.

In the circuit board 30, heat is transferred in a larger amount through electrical conductors such as the electrode patterns and the penetrating conductors, and through the resistance elements. As illustrated in Fig. 5, the first light receiving portion 201 is electrically connected to the stem 40 that is held at the ground potential. Therefore, heat transferred from the stem 40 through the first projecting portion and the second projecting portion is more apt to conduct toward the first light receiving portion 201 than toward the second light receiving portion 202. This causes a difference between an amount of the heat transferred to the first light receiving portion 201 of the pyroelectric element 20 and an amount of the heat transferred to the second light receiving portion 202 of the pyroelectric element 20. However, since the electrode pattern 355 electrically connected to the first light receiving portion 201 and the electrode pattern 356 electrically connected to the second light receiving portion 202 are arranged as described above, the heat exchange between the heat transferred to the electrode pattern 355 and the heat transferred to the electrode pattern 356 is promoted so as to reach an equilibrium state. Accordingly, a difference between an amount of the heat transferred to the electrode pattern 351 and an amount of the heat transferred to the electrode pattern 352 is reduced. As a result, the difference between the amount of the heat transferred to the first light receiving portion 201 of the pyroelectric element 20 through the electrode patterns and the amount of the heat transferred to the second light receiving portion 202 of the pyroelectric element 20 through the electrode patterns is reduced. With the above-described feature, the photodetector 10 can more reliably suppress the false detection attributable to the heat generated in the stem 40 by the strong light from the outside. When the resin substrate 300 is made of FR4, for example, and the electrode patterns are made of copper, for example, it is preferable that the length of a region where the electrode patterns are parallel is not less than 1.0 mm, for example, and that the spacing between the electrode pattern 351 and the electrode pattern 352 is not more than 0.5 mm.

Furthermore, the electrode pattern 355 and the electrode pattern 356 are arranged substantially at a middle point between the electrode pattern 351 connected to the connection member 251 on the same side as the first light receiving portion 201 of the pyroelectric element 20 and the electrode pattern 352 connected to the connection member 252 on the same side as the second light receiving portion 202 of the pyroelectric element 20. As a result, the heat conduction to the first light receiving portion 201 and the heat conduction to the second light receiving portion 202 can be made more even.

Moreover, in the photodetector 10, areas of the electrode pattern 351 and the electrode pattern 352 are substantially the same. With this feature, the amount of the heat transferred to the first light receiving portion 201 and the amount of the heat transferred to the second light receiving portion 202 can be made substantially the same. Accordingly, the photodetector 10 can more reliably suppress the false detection attributable to the heat generated in the stem 40 by the strong light from the outside.

The electrode pattern 357A connected to the electrode pattern 351 and the electrode pattern 358B connected to the electrode pattern 352 have narrower widths than the electrode pattern 355 and the electrode pattern 356. Accordingly, the heat transferred to the electrode pattern 351 and the heat transferred to the electrode pattern 352 can be reduced. With this feature, the photodetector 10 can more reliably suppress the false detection attributable to the heat generated in the stem 40 by the strong light from the outside.

In addition, the electrode pattern 357A and the electrode pattern 357B are connected to the electrode pattern 355 and have narrower widths than the electrode pattern 355. Similarly, the electrode pattern 358A and the electrode pattern 358B are connected to the electrode pattern 356, and each of them has a narrower width than the electrode pattern 356. As a result, heat tends to concentrate in the electrode pattern 355 and the electrode pattern 356, and the above-described heat exchange can be realized with higher efficiency.

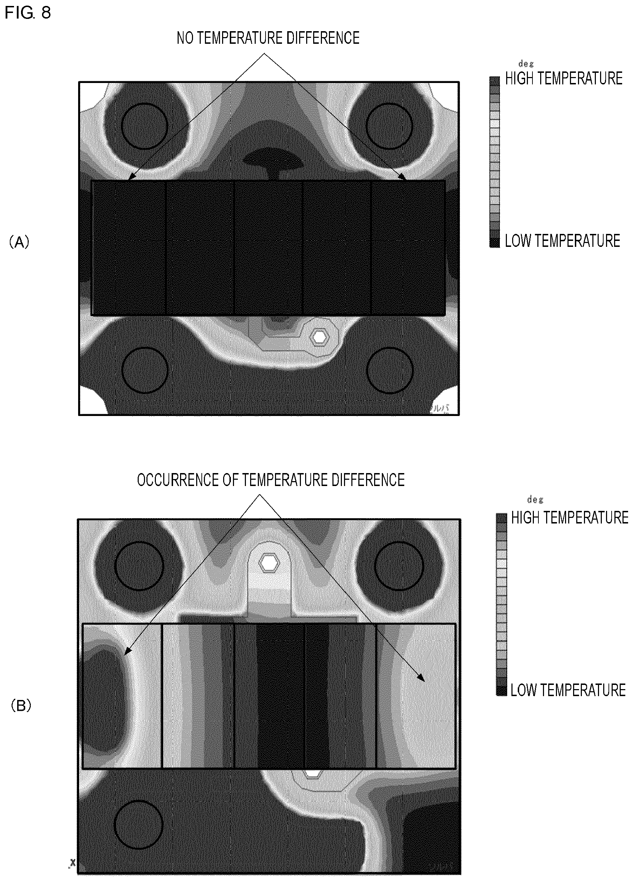

Fig. 8(A) illustrates a simulation result of heat conduction in the structure of the photodetector according to the embodiment of the present invention, and Fig. 8(B) illustrates a simulation result of heat conduction in a comparative structure. The comparative structure is similar to the structure disclosed in the above-described related art. Roughly speaking, the comparative structure is constituted by excluding the conductor pin 512 in the photodetector 10 according to this application. Figs. 8(A) and 8(B) illustrate the simulation results when the same amount of heat is applied with the stem being a heat source. Figs. 8(A) and 8(B) represent temperature distributions in the same temperature range and indicate different levels of temperature with shades of black.

As illustrated in Fig. 8(B), in the comparative structure, a temperature difference, namely a difference in the amount of heat, occurs between a first light receiving portion and a second light receiving portion of a pyroelectric element.

On the other hand, as illustrated in Fig. 8(A), in the photodetector 10 according to this application, a temperature difference, namely a difference in the amount of heat, does not occurs between the first light receiving portion 201 and the second light receiving portion 202 of the pyroelectric element 20.

More specifically, in Fig. 8(A), a difference between an average value of temperature in the first light receiving electrode and an average value of temperature in the second light receiving electrode is about 1/30 of that in Fig. 8(B).

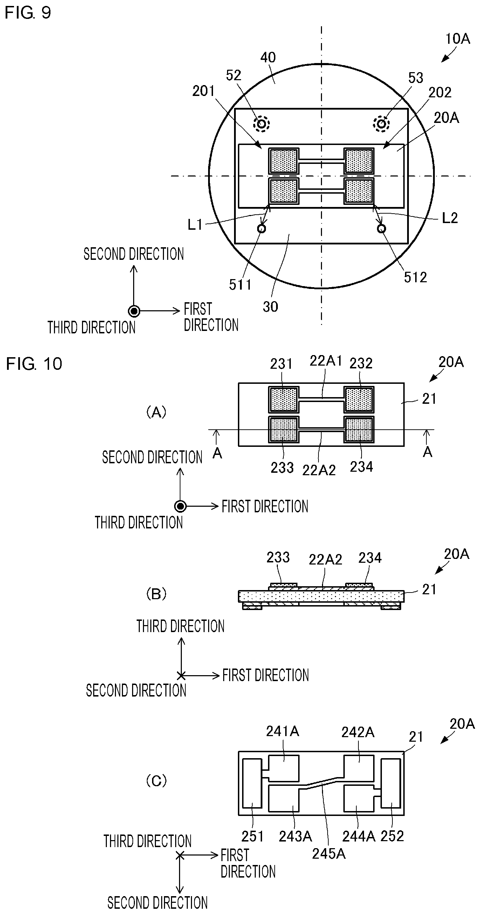

A photodetector according to a second embodiment of the present invention will be described below with reference to the drawings. Fig. 9 is a plan view illustrating a main structure of the photodetector 10A according to the second embodiment of the present invention. Fig. 10(A) is a plan view of a pyroelectric element 20A according to the second embodiment of the present invention, Fig. 10(B) is a side sectional view of the pyroelectric element 20A, and Fig. 10(C) is a bottom view of the pyroelectric element 20A.

As illustrated in Figs. 9, 10(A), 10(B) and 10(C), the photodetector 10A according to the second embodiment is different from the photodetector 10 according to the first embodiment in structure of the pyroelectric element 20A. The other structure of the photodetector 10A is similar to that of the photodetector 10, and description of the similar structure is omitted.

The pyroelectric element 20A is the so-called quad-type pyroelectric element and has a different structure from that of the so-called dual-type pyroelectric element described in the first embodiment. In the pyroelectric element 20A, as in the pyroelectric element 20, the first light receiving portion 201 and the second light receiving portion 202 are arranged side by side in the first direction in association with the circuit board 30 and the stem 40.

As illustrated in Figs. 10(A), 10(B) and 10(C), the pyroelectric element 20A includes a pyroelectric body 21, a detection electrode 22A1, a detection electrode 22A2, a blackened film 231, a blackened film 232, a blackened film 233, a blackened film 234, a connection electrode 241A, a connection electrode 242A, a connection electrode 243A, a connection electrode 244A, a connection electrode 245A, a connection member 251, and a connection member 252.

The pyroelectric body 21 is in the form of a rectangular flat plate with a length in the first direction being longer than that in the second direction. The detection electrode 22A1 and the detection electrode 22A2 are formed on a front surface of the pyroelectric body 21.

Each of the detection electrode 22A1 and the detection electrode 22A2 has a similar structure to that of the detection electrode 22 in the photodetector 10 according to the first embodiment, but has a different width (size in the second direction) from that of the detection electrode 22. The detection electrode 22A1 and the detection electrode 22A2 are arranged apart from each other in the second direction.

The blackened film 231 is formed to cover substantially an entire surface of a rectangular electrode defining the one end side of the detection electrode 22A1. The blackened film 232 is formed to cover substantially an entire surface of a rectangular electrode defining the other end side of the detection electrode 22A1. The blackened film 233 is formed to cover substantially an entire surface of a rectangular electrode defining the one end side of the detection electrode 22A2. The blackened film 234 is formed to cover substantially an entire surface of a rectangular electrode defining the other end side of the detection electrode 22A2.

The connection electrode 241A is constituted by a rectangular portion that is opposed to the rectangular electrode defining the one end side of the detection electrode 22A1 with the pyroelectric body 21 interposed therebetween, a rectangular portion for connection to the outside, and a connection portion that connects between both the rectangular portions. The rectangular portion for connection to the outside is formed near one end of the pyroelectric body 21 in the first direction. The connection member 251 is arranged on an outer surface (rear surface) of the rectangular portion for connection to the outside. The connection electrode 242A is constituted by a rectangular portion that is opposed to the rectangular electrode defining the other end side of the detection electrode 22A1 with the pyroelectric body 21 interposed therebetween. The connection electrode 243A is constituted by a rectangular portion that is opposed to the rectangular electrode defining the one end side of the detection electrode 22A2 with the pyroelectric body 21 interposed therebetween. The connection electrode 244A is constituted by a rectangular portion that is opposed to the rectangular electrode defining the other end side of the detection electrode 22A2 with the pyroelectric body 21 interposed therebetween, a rectangular portion for connection to the outside, and a connection portion that connects between both the rectangular portions. The rectangular portion for connection to the outside is formed near the other end of the pyroelectric body 21 in the first direction. The connection member 252 is arranged on an outer surface (rear surface) of the rectangular portion for connection to the outside.

The connection electrode 245A connects between the connection electrode 242A and the connection electrode 243A.

According to the above-described structure, the first light receiving portion 201 of the pyroelectric element 20 is mainly formed by a region where the pyroelectric body 21 is sandwiched between the detection electrode 22A1 and the connection electrode 241A, and by a region where the pyroelectric body 21 is sandwiched between the detection electrode 22A2 and the connection electrode 243A.

Furthermore, the second light receiving portion 202 of the pyroelectric element 20 is mainly formed by a region where the pyroelectric body 21 is sandwiched between the detection electrode 22A1 and the connection electrode 242A, and by a region where the pyroelectric body 21 is sandwiched between the detection electrode 22A2 and the connection electrode 244A.

In the above-described structure, when viewing the photodetector 10A in plan, a shortest distance (L1 in Fig. 9) between the first light receiving portion 201 of the pyroelectric element 20 and the conductor pin 511 and a shortest distance (L2 in Fig. 9) between the second light receiving portion 202 of the pyroelectric element 20 and the conductor pin 512 are the same.

Hence the photodetector 10A can suppress the false detection attributable to the heat generated in the stem 40 by the strong light from the outside.

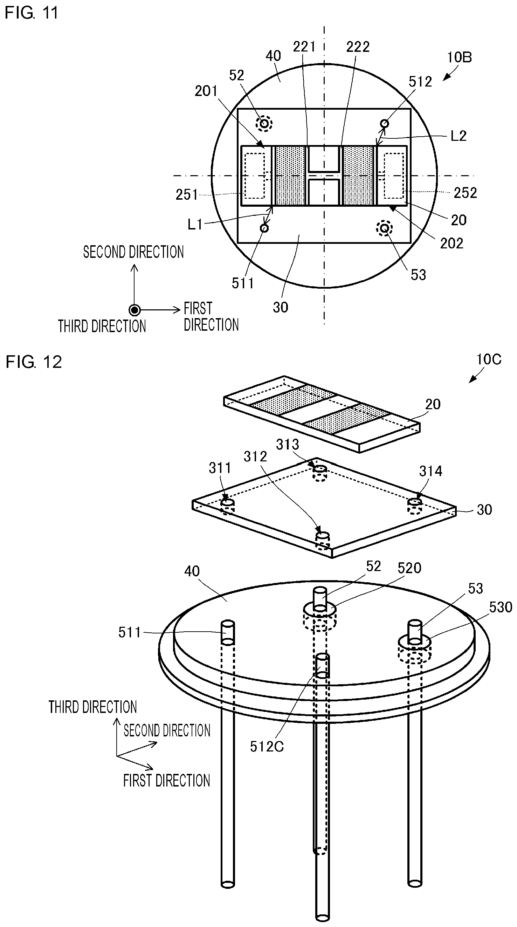

A photodetector according to a third embodiment of the present invention will be described below with reference to the drawing. Fig. 11 is a plan view illustrating a main structure of the photodetector 10B according to the third embodiment of the present invention.

As illustrated in Fig. 11, the photodetector 10B according to the third embodiment is different from the photodetector 10 according to the first embodiment in arrangement of the conductor pin 512 and the conductor pin 53 and in circuit patterns connected to those conductor pins. The other structure of the photodetector 10B is similar to that of the photodetector 10, and description of the similar structure is omitted.

The conductor pin 512 is arranged on the same side as the conductor pin 52 in the second direction with respect to the pyroelectric element 20. The conductor pin 53 is arranged on the same side as the conductor pin 511 in the second direction with respect to the pyroelectric element 20.

In that structure, as in the embodiments described above, when viewing the photodetector 10B in plan, a shortest distance (L1 in Fig. 11) between the first light receiving portion 201 of the pyroelectric element 20 and the conductor pin 511 and a shortest distance (L2 in Fig. 11) between the second light receiving portion 202 of the pyroelectric element 20 and the conductor pin 512 are the same.

Hence the photodetector 10B can suppress the false detection attributable to the heat generated in the stem 40 by the strong light from the outside.

Preferably, when viewing the pyroelectric element 20 in plan, the conductor pin 511 and the conductor pin 512 are symmetrically arranged about the center of the pyroelectric element 20.

A photodetector according to a fourth embodiment of the present invention will be described below with reference to the drawing. Fig. 12 is an exploded perspective view of the photodetector 10C according to the fourth embodiment of the present invention. In Fig. 12, the cover 60 is omitted.

As illustrated in Fig. 12, the photodetector 10C according to the fourth embodiment is different from the photodetector 10 according to the first embodiment in structure of a conductor pin 512C. The other structure of the photodetector 10C is similar to that of the photodetector 10, and description of the similar structure is omitted.

The conductor pin 512C penetrates through the stem 40 in the thickness direction (third direction in Fig. 12) and projects to both the front surface side and the rear surface side of the stem 40.

Even with that structure, similar advantageous effects to those in the above embodiments can also be obtained, and the photodetector 10C can suppress the false detection attributable to the heat generated in the stem 40 by the strong light from the outside.

The features described in the above embodiments can be combined with each other as appropriate, and advantageous effects in accordance with the combinations can be obtained.

While the embodiments have been described above in connection with the case in which the conductor pins necessary in the circuit of the photodetector are utilized for heat conduction, other conductor pins dedicated for heat conduction may be disposed separately from the conductor pins for the circuit. By using the conductor pins, which are necessary in the circuit of the photodetector, for heat conduction, however, it is possible to reduce the number of components of the photodetector, and to realize simplification of the structure and reduction of the size. Reference Signs List
10, 10A, 10B, 10C: photodetector
20, 20A: pyroelectric element
21: pyroelectric body
22, 22A1, 22A2: detection electrode
30: circuit board
32: FET
40: stem
52, 53: conductor pin
60: cover
91: determination unit
201: first light receiving portion
202: second light receiving portion
221: first electrode
222: second electrode
223: connection electrode
231, 232, 233, 234: blackened film
241, 241A, 242, 242A, 243A, 244A, 245A: connection electrode
251, 252: connection member
300: resin substrate
311, 312, 313, 314: through-hole
331, 332, 333, 334: resistance element
345, 351, 352, 353, 354, 355, 356, 357A, 358A, 357B, 358B, 371, 372, 373, 374, 375, 376, 377, 378, 379, 3411, 3412, 3413, 3414, 3611, 3612, 3613, 3614: electrode pattern
511, 512, 512C: conductor pin
520, 530: insulator
600: condenser lens
2411, 2412, 2421, 2422: rectangular portion

## Claims

1. A photodetector comprising:
a stem having electrical conductivity;
a pyroelectric element arranged on front surface side of the stem and including a first light receiving portion and a second light receiving portion that are connected in series and that generate voltages of opposite polarities upon receiving light; and
a first projecting portion and a second projecting portion each of which has a shape projecting from a front surface of the stem and has thermal conductivity,
wherein a shortest distance for heat conduction between the first projecting portion and the first light receiving portion and a shortest distance for heat conduction between the second projecting portion and the second light receiving portion are same.

2. A photodetector comprising:
a stem having electrical conductivity;
a pyroelectric element arranged on front surface side of the stem and including a first light receiving portion and a second light receiving portion that are connected in series and that generate voltages of opposite polarities upon receiving light; and
a first projecting portion and a second projecting portion each of which has a shape projecting from a front surface of the stem and has thermal conductivity,
wherein, when viewing the front surface of the stem from above, a physical shortest distance between the first projecting portion and the first light receiving portion and a physical shortest distance between the second projecting portion and the second light receiving portion are same.

3. The photodetector according to Claim 1 or 2, wherein, when viewing the pyroelectric element in plan, a pair of the first projecting portion and the second light receiving portion and a pair of the first light receiving portion and the second light receiving portion are symmetrically arranged for each pair about a center or a center line of the pyroelectric element.

4. The photodetector according to any one of Claims 1 to 3, further comprising a circuit board in form of a flat plate, the circuit board including a circuit electrically connected to the pyroelectric element,
wherein the pyroelectric element is mounted to a surface of the circuit board, and
the first projecting portion and the second projecting portion are physically and electrically connected to the circuit board.

5. The photodetector according to Claim 4, wherein the circuit board includes:
a first conductor pattern electrically connected to the first light receiving portion of the pyroelectric element; and
a second conductor pattern electrically connected to the second light receiving portion of the pyroelectric element,
the first conductor pattern and the second conductor pattern having zones that are arranged parallel and apart from each other when viewing the circuit board in plan.

6. The photodetector according to Claim 5, wherein the first light receiving portion of the pyroelectric element is electrically connected to the first conductor pattern through a first connection member,
the second light receiving portion of the pyroelectric element is electrically connected to the second conductor pattern through a second connection member, and
when viewing the circuit board in plan, the first conductor pattern and the second conductor pattern have zones in which the first conductor pattern and the second conductor pattern are arranged parallel to be kept apart from each other at a middle point between the first connection member and the second connection member.

7. The photodetector according to Claim 5 or 6, wherein the first conductor pattern and the second conductor pattern have narrower widths in other zones than the zones in which the first conductor pattern and the second conductor pattern are arranged parallel.

8. The photodetector according to Claim 7, wherein the other narrower zones than the zones in which the first conductor pattern and the second conductor pattern are arranged parallel are formed on both sides of the parallel zone in each of the first conductor pattern and the second conductor pattern.

9. The photodetector according to any one of Claims 4 to 8, wherein at least one of the first projecting portion and the second projecting portion is a grounding lead-out terminal that grounds a circuit electrically connected to the pyroelectric element.
